# EUROPEAN PATENT APPLICATION

(11) **EP 2 988 142 A2**
(43) Date of publication of application: **24.02.2016**
(21) Application number: 15181165.0
(22) Date of filing: 14.08.2015
(51) Int. Cl.: G01R 31/327, H02H 3/00

(54) **MONITORING UNIT FOR MONITORING A SWITCHING STATE AND/OR AN ELECTRICAL CONDITION OF A HIGH-VOLTAGE BREAKER SYSTEM, MONITORING SYSTEM AND METHOD**

(30) Priority: 22.08.2014 DE 102014112051
(71) Applicant: ABB Technology AG, 8050 Zürich (CH)
(72) Inventor: ZLATANSKI, Martin, 8700 Küsnacht (CH); HOCHLEHNERT, Moritz, 79771 Klettgau-Griessen (DE); MARINKOVIC, Stevan, 5430 Wettingen (CH); MARET, Yannick, 5405 Baden-Dättwil (CH)
(74) Representative: ABB Patent Attorneys

(57) **Abstract**

The invention relates to a monitoring unit (20) for monitoring a switching state and/or electrical condition of a high-voltage breaker system (1), comprising:
- an injection unit (28) configured to inject a test signal into the breaker system (1);
- a receiving unit (29) for receiving an injected test signal from the breaker system (1); and
- a coupling switch (27) for either coupling the injection unit (28) or the receiving unit (29) to the breaker system (1).

## Description

### Technical field

The present invention relates to the field of monitoring breaker systems, particularly breaker systems for high-voltage power applications. In particular, the present invention relates to a monitoring system for continuously monitoring switching states and/or electrical conditions in a breaker system. Furthermore, the present invention relates to the field of monitoring the conditions of additional components in breaker systems.

### Related art

In high-voltage breaker systems, such as generator circuit breaker systems (GCB systems), the switching states of the main breakers in the system are conventionally determined by the switching states of auxiliary switches triggered by the movement of respective operating mechanisms that drive the breakers. The auxiliary switch assembly is mechanically coupled to the operating mechanism of the breaker, and is configured to generate electrical signals indicating the position of the operating mechanism, thereby indicating the switching state of the breaker.

Although this approach for monitoring the switching state of the circuit breaker is simple and easy to implement, the indirect nature of the measurement might result in an incorrect monitoring of the switching state in the breaker system in case of a malfunction of a mechanical linkage between the drive, the operating mechanism and the respective circuit breaker. Particularly, in systems where one operating mechanism is used to drive all phases of the circuit breaker a situation may occur in which the breaker is not in the same state for all phases which leads to serious asymmetrical faults.

Furthermore, breaker systems may include additional serially connected disconnectors which are driven directly, so that no auxiliary switches are available to monitor the state of the disconnector.

Additionally, breaker systems may include earthing switches that are used for safety purposes during maintenance. An earthing switch should not be closed if either the breaker or the disconnector is closed. Conversely, neither the breaker nor the disconnector should be closed if any earthing switch is closed. Switching states of the earthing switches are safety relevant and a direct way to determine them is of high interest.

In addition to the switching states, electrical states indicating electrical conditions of components of the breaker system further need to be monitored in order to assess their remaining lifetime in the breaker system. This allows to detect, maintain or replace critical components before a failure occurs.

It is an object of the present invention to provide an improved system with a simple setup and a low number of monitoring units for monitoring the switching states and/or electrical conditions of switches, such as main breakers, disconnectors, earthing switches and the like, in a high-voltage breaker system.

### Summary of the invention

This object has been achieved by the monitoring system according to claim 1, the combination of the monitoring system and a breaker system and the method for operating a monitoring system according to the further independent claims.

Further embodiments are indicated in the depending subclaims.

According to a first aspect, a monitoring system for monitoring a switching state and/or electrical condition of a high-voltage circuit breaker system is provided, comprising at least two monitoring units, each monitoring unit (20) comprising:
- an injection unit configured to inject a test signal into the breaker system;
- a receiving unit for receiving an injected test signal from the breaker system; and
- a coupling switch configured to selectively either couple the injection unit or the receiving unit to the breaker system, wherein each of the at least two monitoring units is coupled to exactly one of at least two nodes (N1, N2, N3) of the high-voltage circuit breaker system (1).

The above monitoring system is configured to be operated in a breaker system where a test signal, e. g. a transient or periodic test signal, is injected into one monitoring node of the breaker system and a corresponding test signal is received at least in one of the other monitoring nodes of the breaker system. Particularly, in systems where a number of circuit breakers and/or disconnectors are coupled in series, it is generally not possible -with only two monitoring units- to analyze all relevant states and conditions of the circuit breakers and/or disconnectors, if one of these is in an opened state. Substantially, for monitoring the switching state and/or electrical condition of a circuit breaker or disconnector in a breaker system, an injecting unit and a receiving unit are necessarily connected to each terminal node of the circuit breaker or disconnector, respectively.

As each of the injection unit and receiving unit has to be coupled to the main duct by means of a coupling unit, the overall capacitance on the main line may increase with each additional monitoring unit. The monitoring unit therefore includes a coupling means as well as a coupling switch which is configured to switch either an injector unit or receiving unit with the coupling means, so that the monitoring unit can either act as the injecting part or as a receiving part. This allows for coupling the nodes between circuit breakers and disconnectors with the monitoring unit by a single coupling means, so that no additional capacitance is applied. Hence, a number of monitoring units can be coupled to different nodes or a high-voltage system, wherein each of the monitoring units being capable of operating as an injection part and a receiving part, so as to analyze and monitor the components coupled between the two respective nodes.

According to an embodiment, a coupling means may be provided for coupling to a node of a breaker system, wherein particularly the coupling means provides a galvanic insulation to the coupled breaker system.

Furthermore, in case the coupling switch couples the receiving unit to the breaker system, a monitoring unit controller may be configured to:
- generate footprint data from a received test signal; and
- compare the footprint data with the provided reference footprint data to obtain an indication whether or not the electrical condition of the breaker system belongs to a fully operational breaker system.

According to an embodiment a monitoring unit controller may be configured to:
- detect an existence and/or characteristics of a test signal received by the receiving unit; and
- determine an indication of the switching state of the breaker system depending on the existence and/or characteristics of a test signal received.

The monitoring may be performed by comparing the generated footprint data to previously stored reference footprint data. The footprint data is extracted from the received test signal and represents the behavior of the portion of the breaker system between the respective monitoring node coupled to a monitoring unit with the injector unit activated and the respective monitoring node coupled to a monitoring unit with the receiving unit activated.

According to a further embodiment, in case the coupling switch couples the receiving unit to the breaker system, a (the) monitoring unit controller may be configured to:
- receive an indication about a switching state configuration of the breaker system; and
- check whether the received switching state configuration corresponds to configuration determined by the existence and/or characteristics of the test signal received.

It may be provided that a monitoring control unit is coupled to each of the monitoring units to control the monitoring units in order to make one of the monitoring units act to inject the test signal while making the other monitoring units act to receive an injected test signal.

Furthermore, the monitoring control unit may be configured to successively control the monitoring units, so that two or more of the monitoring units successively act to inject the test signal.

Moreover, the monitoring units may be controlled by the monitoring control unit to successively make one of the monitoring units inject the test signal while making the other monitoring units receive the injected test signal.

According to a further aspect, a combination of a breaker system and a monitoring system is provided, wherein the breaker system has at least one breaker defining at least two monitoring nodes, wherein the monitoring units are coupled to each of the monitoring nodes.

According to a further aspect, a method for operating the above monitoring unit is provided, comprising the steps of:
- controlling the monitoring units to make one of the monitoring units act to inject the test signal while making the other monitoring units act to receive an injected test signal; and
- signaling a failure depending on at least one of the received test signals.

### Brief description of the drawings

Embodiments will be described in more detail in conjunction with the accompanying drawings, in which:
- Figure 1: shows a schematic single-phase diagram of a generator circuit breaker system including three monitoring units;
- Figure 2: shows a schematic diagram of a monitoring unit as applied in the generator circuit breaker system of Figure 1.

### Description of embodiments

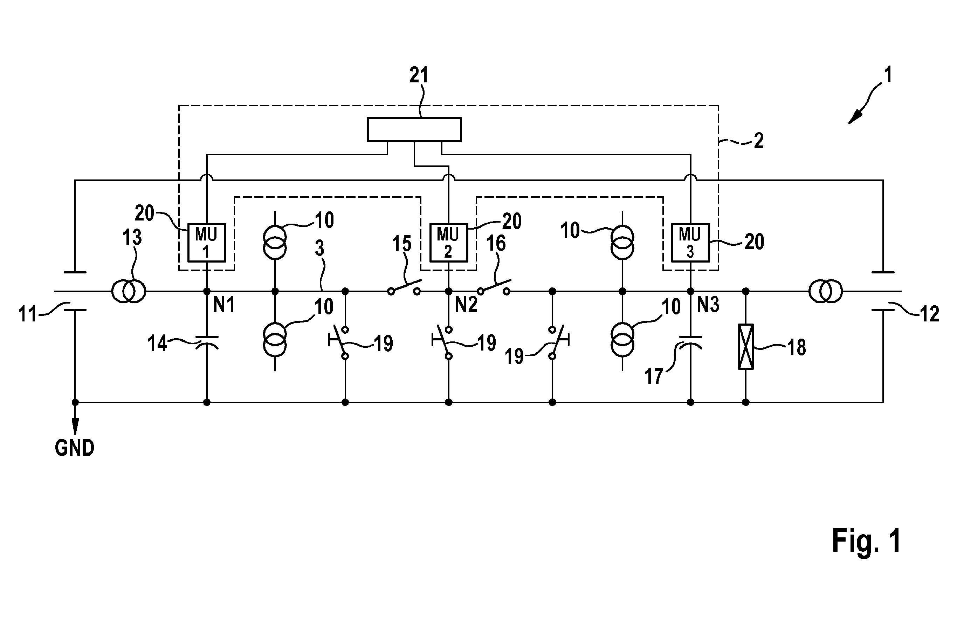

Figure 1 schematically shows a generator circuit breaker system 1 with a power input terminal 11 (to which e.g. a power generator may be connected) and a power output terminal 12 (to which e.g. a step-up transformer to the grid may be connected). The generator circuit-breaker system 1 is an example for a high-voltage system including a circuit breaker, a disconnector and further components for each phase as needed in high-voltage power applications. The illustrated generator circuit breaker system 1 is, for reasons of simplicity, depicted as a single-phase system while for a multiple phase system the shown system exists in the respective number of times.

For monitoring electrical states, particularly switching states of breakers, disconnectors, and earthing switches as well as the conditions of further electrical components, a monitoring system 2 is provided.

The circuit breaker system 1 comprises a main duct 3 for transferring electrical power. The main duct 3 includes serially connected components, such as a circuit breaker 15, and other electrical components as a disconnector 16 and a current transformers 13, thereby forming nodes. The nodes may be coupled to further electrical components. The nodes may be used to monitor an electrical state of the circuit breaker system 1.

In detail, the input terminal 11 is connected via a current transformer 13 to a first monitoring node N1. The first monitoring node N1 is coupled to a surge capacitor 14 with a ground potential GND. Furthermore, the first node N1 is coupled via transformers 10 to a surveying system (not shown) which is, e. g., configured to control the voltage on the main duct 3.

The first node N1 is coupled to a second monitoring node N2 via a circuit breaker 15.

Furthermore, the second monitoring node N2 is coupled to the third node N3 via a disconnector 16. While the circuit breaker 15 is capable of carrying and switching high voltages and high currents, the disconnector 16 mainly serves for decoupling the nodes N1 and N2 from the output terminal 12, when the circuit breaker 15 is opened. The disconnector 16 is usually not capable of switching high currents.

Each of the monitoring nodes N1, N2, N3 is coupled via an earthing switch 19 to a predefined potential, preferably a ground potential GND. The earthing switches 19 serve for coupling each node N1, N2, N3 to the ground potential GND in case of maintenance of the circuit breaker system 1.

Furthermore, the third monitoring node N3 is coupled to the ground potential GND by means of a second surge capacitor 17 and a surge arrestor 18. The second surge capacitor 17 and the surge arrestor 18 serve for protecting the components in the main duct 3 against an overvoltage during switching cycles or lightning impact on the grid.

For monitoring the state of the circuit breaker system 1, each of the first, second and third monitoring nodes N1, N2, N3 may be coupled to a respective monitoring unit 20; 20', 20",20"'. The monitoring units 20 are coupled to a monitoring control unit 21 and together form the monitoring system 2. With other words, each of the first, second and third monitoring nodes N1, N2, N3 may be coupled to exactly one monitoring unit 20.

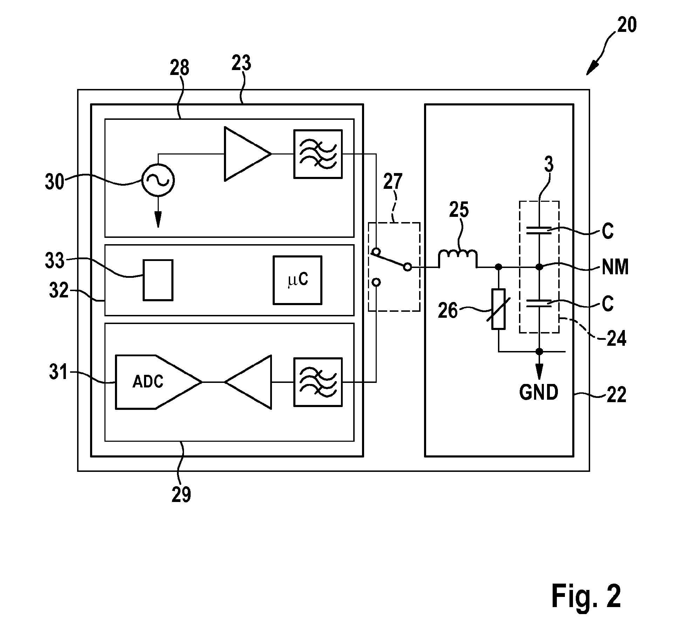

Figure 2 schematically shows a monitoring unit 20 as used in the monitoring system 2 of Figure 1. Each of the monitoring units 20 comprises a coupling means 22 which couples a monitoring circuit 23 to the main duct 3. The coupling serves as galvanic separation between the high voltage regime of the main duct 3 and the low voltage regime of the monitoring portion of the monitoring unit 20, e. g. by means of a capacitive coupler 24.

The capacitive coupler 24 may be built with a so-called capacitive voltage divider, the top capacitor (connected to the main duct) allows for maintaining electrical insulation of the main duct 3 while the bottom capacitor is connected to the earth/ground. The bottom capacitor may also be omitted and so replaced by a parasitic capacitor due the construction of the capacitive voltage divider. A middle node NM of the capacitive voltage divider 24 is connected to a peaking inductor 25 in order to obtain a series resonant circuit and may provide a low-impedance path for the test signal to the main duct 3. A varistor 26 may be connected between the middle node NM and the ground potential GND to protect the monitoring circuit 23 from overvoltages.

The coupling means 22 is connected via a coupling switch 27 to the monitoring circuit 23. The monitoring circuit 23 comprises an injection unit 28 for providing a test signal and a receiving unit 29 for receiving an injected test signal. Depending on the switching state of the coupling switch 27, either the injection unit 28 or the receiving unit 29 are activated, i. e. coupled to the main duct 3 via the coupling means 22.

The test signal injected by the injection unit 28 may include a number of frequency components provided by a test signal generator 30. The test signal is provided continuously or according to a predetermined time scheme.

The receiving unit 29 is capable of receiving an injected test signal, digitalizing it by means of an analog-digital converter 31 and providing the digitalized test signal to a monitoring unit controller 32. The monitoring unit controller 32 analyzes the digitalized received test signal and extracts footprint data. The footprint data may be data describing the characteristics of the received test signal which may reflect the behavior of a portion of the circuit breaker system 1. For instance, the footprint data may describe the signal strength of different frequency components that are included in the injected test signal.

At least two of the monitoring nodes N1, N2, N3 are coupled to a respective monitoring unit 20 (MU1, MU2, MU3). The monitoring units 20 are connected with the monitoring control unit 21. The monitoring control unit 21 may be configured to receive footprint data and to provide a switching control signal to each of the coupling switches 27 of the monitoring units 20.

The monitoring control unit 21 may be in control of the monitoring process. The switching state and the electrical condition of the breaker system 1 is characterized by the behavior of the breaker system 1 with respect to the characteristics of the received test signal at a monitoring node N1, N2, N3 depending on the injected test signal and the respective monitoring node N1, N2, N3 where the test signal is injected.

The characteristic of test signals received at at least one of the monitoring nodes N1, N2, N3 and injected by at least one of the monitoring units 20 at one of the other monitoring nodes N1, N2, N3 gives an indication about the switching state and/or electrical condition of the breaker system 1.

The monitoring unit controller 32 of any of the monitoring units 20 may include a memory 33 containing stored reference footprint data for each monitoring node N1, N2, N3 being connected with a monitoring unit 20 with their injection unit 28 activated, respectively, wherein the reference footprint data indicate a characteristic behavior of a breaker system 1 which is in full working condition. Furthermore, the reference footprint data may be stored depending on the state of the breaker switches. The reference footprint data may be successively obtained in a calibration run in each of the monitoring units 20 in which the receiving unit 29 are activated, with the other monitoring units 20 in which the injection unit 28 are activated.

For monitoring the state of the high-voltage system, a reference footprint is acquired for each switching state of the breaker system 1 or at least for the present switching state. A reference footprint comprises data initially recorded for (a subset of) all possible configurations of the coupling switches 27. The footprints are stored into a memory 33. The reference footprint data comprises a data set obtained by sequentially setting each monitoring unit 20 with the injection unit 28 activated while the remaining monitoring units 20 are switched to have the receiving unit 29 activated. The reference footprint may include information about the switching state of the breaker system 1 and its data may include parameters (or indications about characteristics) about the received test signal (for example amplitude, phase, time-series representation) at one or more different frequencies for the test signal in a specific coupling switch configuration and/or configuration of the breaker system. Each of the injection units 28, if coupled with the respective monitoring node N1, N2, N3, provides a test signal or a sequence of test signals at one or more different frequencies, while the receiving unit 29 of a monitoring unit 20 coupled to another one of the monitoring nodes N1, N2, N3 provides the measurement, and extracts the footprint data.

The monitoring is performed in monitoring process steps, wherein each process step includes selecting one of the monitoring units 20 with the respective injection unit 28 activated while at least one of the other monitoring units 20 have the receiving unit 29 activated, analyzing the received test data and generating footprint data thereof. The monitoring process steps may be performed cyclically, preferably with changing the monitoring unit 20 whose injection unit 28 is activated.

After each of the monitoring process steps, each of the monitoring unit controllers 32 of the monitoring units 20 with the receiving unit 29 activated may perform a comparison between the footprint data generated from the received test signal and the reference footprint data provided in their respective memory 33 and associated to the respective injecting node. Differences exceeding a critical threshold result will result in triggering an adequate protection process, such as emergency off-switching.

In the estimation of the switching state of the breaker system, the measured footprint is compared to all reference footprints. The reference footprint whose data is most similar to the measured one defines the estimated switching state of the breaker system 1. The estimated switching state of the breaker system may be used to allow or block certain breaker operations. For example, if any earthing switch 19 is closed neither the circuit breaker 15 nor the disconnector 16 can be opened; conversely if either the breaker 15 or the disconnector 16 is closed, the earthing switches 19 cannot be closed. The estimated switch state configuration of the breaker system 1 may furthermore be compared with one delivered through other means (e.g. mechanical or visual) and an alarm may be raised if the configurations differ.

Another possible way to estimate the switching state of the breaker system 1 is to check whether the injected test signal is transmitted between nodes (N1, N2, N3). For example, if the monitoring unit 20 connected to N2 injects a test signal and the injected test signal is received by the monitoring unit 20 connected to N1 (N3), it means that the circuit breaker 15 (disconnector 16) is closed. On the other hand, if the test signal is not received by the monitoring unit 20 connected to N1 (N3), it means that either the circuit breaker 15 (disconnector 16) is opened or that at least one earthing switch 19 is closed. The discrimination between these switching states can be performed by analysing the parameters/characteristics of the received test signal at different frequency (e.g. the earthing switch 19 exhibits low impedance for all frequency components whereas the breaker 15 and the disconnector 16 acts rather like a capacitor-the transmission strength should increase with increasing frequency) and/or by comparing the measured footprint with the reference footprints.

The control unit 21 operates the monitoring system 2 by controlling the coupling switches 27 of each of the monitoring units 20 such that in succeeding monitoring process steps only the coupling switch 27 of one of the monitoring units 20 is switched to make the respective monitoring unit 20 act as an injection unit 28 while the coupling switches 27 of the other monitoring units 20 are switched to make the respective monitoring unit 20 act as a receiving unit 29. The switching states are kept until the injected test signal has been analyzed by all of the monitoring units 20 switched to make the monitoring unit 20 act as a receiving unit 29 to obtain respective footprint data and the comparison between footprint data and reference footprint data has been carried out.

Subsequently, the next coupling switch 27 of a next monitoring unit 20 is switched to make the respective monitoring unit 20 act as an injection unit 28, while the other monitoring units 20 are switched to act as receiving units 29. This is performed until each of the monitoring units 20 has been operated to act as an injection unit 28.

To control this operation, the control unit 21 may submit an injection command to the respective monitoring unit 20 to make it act as an injection unit 28 and to provide a receiving command including identification data to the other monitoring unit(s) 20. The identification data serves to identify the respective monitoring unit 20 which will provide the test signal as the injection unit 28, to the other monitoring unit(s) 20. This allows the other monitoring units 20 to refer to the respective reference footprint data in their respective memories 33 for comparison.

In contrast to above configuration comprising a control unit 21, other configurations may be provided without any control unit 21. In such configurations the monitoring units 20 are interconnected to provide signal communication among one another. This may be performed by means of a communication scheme according to which the monitoring units 20 are successively switched to make the respective monitoring unit 20 act as an injection unit 28 while the other monitoring units 20 are switched to act as receiving units 29.

### Reference list

- 1: breaker system
- 10: voltage transformers
- 11: power input terminal
- 12: power output terminal
- 13: current transformer
- 14: first surge
- 15: circuit breaker
- 16: disconnector
- 17: second surge capacitor
- 18: surge arrestor
- 19: grounding switch
- 2: monitoring system
- 20: monitoring unit
- 21: monitoring control unit
- 22: coupling means
- 23: monitoring circuit
- 24: capacitive voltage divider
- 25: peaking inductor
- 26: varistor
- 27: coupling switch
- 28: injection unit
- 29: receiving unit
- 30: test signal generator
- 3: main duct
- 31: analog-digital converter
- 32: monitoring unit controller
- 33: memory
- C: capacitor
- N1, N2, N3: monitoring nodes
- NM: middle node

## Claims

1. Monitoring system (2) for monitoring a switching state and/or electrical condition of a high-voltage circuit breaker system (1), comprising at least two monitoring units (20; 20', 20", 20"'), each monitoring unit (20) comprising:
- an injection unit (28) configured to inject a test signal into the high-voltage circuit breaker system (1);
- a receiving unit (29) for receiving an injected test signal from the high-voltage circuit breaker system (1); and
- a coupling switch (27) configured to selectively either couple the injection unit (28) or the receiving unit (29) to the high-voltage circuit breaker system (1),
wherein each of the at least two monitoring units (20) is coupled to exactly one of at least two monitoring nodes (N1, N2, N3) of the high-voltage circuit breaker system (1).

2. Monitoring system (2) according to claim 1, wherein a coupling means (22) is provided for each monitoring unit (20) for coupling to exactly one of the at least two monitoring nodes (N1, N2, N3), wherein the coupling means (22) provides a galvanic insulation to the coupled high-voltage circuit breaker system (1).

3. Monitoring system (2) according to claim 1 or 2, wherein, in case the coupling switch (27) couples the receiving unit (29) to the high-voltage circuit breaker system (1), a monitoring unit controller (32) is configured to:
- generate footprint data from a received test signal; and
- compare the footprint data to provided reference footprint data to obtain an indication whether or not the electrical condition of the high-voltage circuit breaker system (1) belongs to a fully operational high-voltage circuit breaker system (1).

4. Monitoring system (2) according to claim 1 or 2, wherein the monitoring unit controller (32) is configured to:
- detect an existence and/or characteristics of a test signal received by the receiving unit (29); and
- determine an indication of the switching state of the high-voltage circuit breaker system (1) depending on the existence and/or characteristics of a test signal received.

5. Monitoring system (2) according to claim 4, wherein, in case the coupling switch (27) couples the receiving unit (29) with the high-voltage circuit breaker system (1), a monitoring unit controller (32) is configured to:
- receive an indication about a switching state configuration of the high-voltage circuit breaker system (1); and
- check whether the received switching state configuration corresponds to the configuration determined by the existence and/or characteristics of the test signal received.

6. Monitoring system (2) according to any of the claims 1 to 5, wherein a monitoring control unit (21) is coupled to each of the at least two monitoring units (20) to control the monitoring units (20) in order to make one of the monitoring units (20) act to inject the test signal while making the other monitoring units (20) act to receive an injected test signal.

7. Monitoring system (2) according to claim 7, wherein the monitoring control unit (21) is configured to successively control the monitoring units (20), so that two or more of the monitoring units (20) successively act to inject the test signal.

8. Monitoring system (2) according to any of the claims 5 to 7, wherein the monitoring units (20) are interconnected to successively make one of the monitoring units (20) act to inject the test signal while making the other monitoring units (20) act to receive the injected test signal.

9. Combination of a circuit breaker system (1) and a monitoring system (2) according to any of the claims 1 to 8, wherein the high-voltage circuit breaker system (1) comprises at least one circuit breaker (15) defining the at least two monitoring nodes (N1, N2, N3), and wherein exactly one monitoring node (N1, N2, N3) being coupled to a contact side of the circuit breaker (15).

10. Combination of a high-voltage circuit breaker system (1) and a monitoring system (2) according to claim 9, wherein the high-voltage circuit breaker system (1) comprises a main duct (3) for transferring electrical power, wherein the at least one circuit breaker (15) and at least another electrical component are connected in series in the main duct (3) and defining at least three monitoring nodes (N1, N2, N3), wherein each of the at least three monitoring nodes (N1, N2, N3) is coupled to a exactly one of the monitoring units (20).

11. Combination of a high-voltage circuit breaker system (1) and a monitoring system (2) according to claim 9 or 10, wherein the high-voltage circuit breaker system (1) comprises at least two earthing switches (19) and each of the at least two monitoring nodes (N1, N2, N3) is electrically coupled via one of the at least two earthing switches (19) to ground potential (GND).

12. Combination of a circuit breaker system (1) and a monitoring system (2) according to any of the claims 9 to 11, wherein the high-voltage circuit breaker system (1) comprises at least one surge capacitor (14, 17), and wherein the at least one surge capacitor (14, 17) is coupled to a first of the monitoring nodes (N1, N2, N3).

13. Method for operating a monitoring system (2) according to any of the claims 1 to 8, comprising the steps of :
- controlling the at least two monitoring units (20) to make one of the monitoring units (20) act to inject the test signal while making the other monitoring units (20) to act to receive an injected test signal;
- signaling a failure depending on at least one of the received test signals.

14. Method according to claim 13, wherein the switching state configuration of the breaker system (1) is estimated depending on the existence and/or characteristics of the test signal received.

15. Method according to claim 13 or 14, wherein an existence and/or characteristics of a test signal received is detected and an indication whether or not the switching state of the high-voltage circuit breaker system (1) corresponds to the received indication about the switching state configuration of the high-voltage circuit breaker system (1) is obtained depending on the existence and/or the characteristics of the test signal received.
